# EUROPEAN PATENT SPECIFICATION

(11) **EP 2 185 304 B1**
(45) Date of publication and mention of the grant of the patent: **17.07.2013**
(21) Application number: 08829929.2
(22) Date of filing: 05.09.2008
(51) Int. Cl.: B22F 9/30, C22C 1/04, H01B 1/02

(54) **METHOD FOR THE PRODUCTION OF A MULTI-ELEMENT ALLOY POWDER CONTAINING SILVER AND AT LEAST TWO NON-SILVER CONTAINING ELEMENTS**
vERFAHREN ZUR HERSTELLUNG EINES PULVERS AUS EINER MULTIELEMENTLEGIERUNG MIT SILBER UND MINDESTENS ZWEI SILBERFREIEN ELEMENTEN
PROCÉDÉ DE FABRICATION D'UNE POUDRE D'ALLIAGE À MULTIPLES ÉLÉMENTS CONTENANT DE L'ARGENT ET AU MOINS DEUX ÉLÉMENTS NE CONTENANT PAS D'ARGENT

(30) Priority: 07.09.2007 US 967873 P
(43) Date of publication of application: 19.05.2010
(73) Proprietor: E. I. du Pont de Nemours and Company, Wilmington, DE 19898 (US)
(72) Inventor: GLICKSMAN, Howard, David, Durham, North Carolina 27707 (US); DIEMER, Jr., Russell, Bertrum, Wilmington, Delaware 19803 (US); COCKER, John, Badminton, Avon (GB)
(74) Representative: Hoffmann, Benjamin
(86) International application number: PCT/US2008/075349
(87) International publication number: WO 2009/032984

(56) References cited:
- EP-A- 0 591 881
- EP-A- 0 662 521
- EP-A- 1 386 708
- US-B1- 6 338 809

## Description

### BACKGROUND

### Field of Invention

The invention is directed to methods of manufacturing multi-element, finely divided, alloy powders containing silver and at least two non-silver containing elements.

### Technical Background of the Invention

Metal and metal alloy powders have many important applications, especially in electronics and dental industries. Mixtures and alloys of silver and palladium are widely used in conductor compositions for hybrid integrated circuits, multilayer ceramic capacitors, actuators and other uses. Alloys of silver and palladium are less expensive than gold or platinum compositions and are compatible with most dielectric and resistor systems. The addition of palladium to silver greatly enhances the compatibility of the circuit for soldering, raises the melting point of the silver for compatibility with the dielectric firing temperatures and reduces the problems of silver migration which can cause degradation of the dielectric properties and shorting.

Bi-metallic mixtures and alloys of silver and palladium powders are used in internal electrode materials for multilayer ceramic devices, ceramic piezoelectric actuators, and other ceramic devices. Ceramic piezoelectric actuators are used, for example, for actuating a mechanical component such as a valve or the like (see, e.g. United States patent 6,411,018). A typical composition used in ceramic piezoelectric actuators (see, e.g., United States patent 6,700,311) is a 70% Ag 30% Pd which has a melting point higher than the temperatures used to sinter the ceramics. The properties of the metallic components of thick film inks intended for the internal electrodes of devices are extremely important because compatibility is required between the metal power and the organic medium of an ink and between the ink itself and the surrounding dielectric material. Metal particles that are uniformly sized, approximately 0.1 - 1.0 µm in diameter, pure, crystalline, and unagglomerated are required to maximize the desired qualities of a conductive thick film paste.

A piezoelectric ceramic generates an electric voltage when a force is applied to it and produces a displacement or a force when voltage is applied to it. This makes it very useful as actuators or sensors. Ceramic piezoactuators are composed of a multiplicity of thin, ceramic piezoactive layers. Each layer is separated from the others by an internal electrode layer which can be electrically contacted and driven. Piezoactuators of this type are essentially composed of a PZT ceramic (i.e. Pb (TiₓZr₁₋ₓ) O₃) where 0.4<x<0.6 with internal electrodes mounted between each layer. These layers are co-fired to form a stack which as a result of the inverse piezoelectric effect undergoes an expansion or compression in response to the application of an external voltage. Typical driving voltages are between 100 and 300 volts with a resulting alteration of 0.1% to 0.3 %.

The internal electrodes in piezoelectric ceramic bodies are made of materials whose melting point is higher that the temperature necessary for sintering the ceramic. In addition, the materials of the internal electrodes are oxidation stable.

One disadvantage in using silver in the internal electrodes is that during sintering in a co-firing process, the result can be a diffusion of silver from the electrodes into the neighboring insulating layers degrading the ceramic properties decreasing the piezoelectric effect and decreasing the insulation resistance leading to electrical breakdowns. Another disadvantage of using 30% Pd is that the palladium cost is still relatively high. Reducing the amount of Pd causes a further increase in silver which causes more undesirable diffusion effects.

There are many methods currently used to manufacture metal powders. These include chemical reduction methods, physical processes such as atomization or milling, thermal decomposition, and electrochemical processes. These processes tend to be very hard to control and give irregular shaped particles that are agglomerated. In addition, these processes are either unable to make alloy particles that contain greater than two elements or the particle sizes are very large and the alloy ratios are very hard to control.

The aerosol decomposition process involves the conversion of a precursor solution to a powder. (See U. S. 6,338,809.) This process involves the generation of droplets, transport of the droplets with a gas into a heated reactor, the removal of the solvent by evaporation, the decomposition of the salt to form a porous solid particle, and then the densification of the particle to give fully dense, spherical pure particles Conditions are such that there is no interaction of droplet-to-droplet or particle-to-particle'and there is no chemical interaction of the droplets or particles with the carrier gas.

### Summary of the Invention

The invention is directed to a method for the manufacture of a multi-element, finely divided, alloy powder containing silver and at least two non-silver containing elements comprising the sequential steps:
a. forming a solution of a mixture of a thermally decomposable silver containing compound with at least two additional, non-silver containing thermally decomposable metal compounds in a thermally volatilizable solvent characterised in that a co-solvent is added to act as a reducing agent;
b. forming an aerosol consisting essentially of finely divided droplets of the solution from step A dispersed in a carrier gas, the droplet concentration which is below the concentration where collisions and subsequent coalescence of the droplets results in a 10% reduction in droplet concentration, where the carrier gas is an inert gas that does not react with the metals included in the multi-metallic particles;
c. heating the aerosol to an operating temperature above the decomposition temperature of the silver-containing compound and the non-silver containing compounds but below the melting point of the resulting multi-metallic alloy by which(1) the solvent is volatilized, (2) the silver-containing compound and the non-silver containing compounds are decomposed to form finely divided particles, (3) the particles from an alloy and are densified; and
d. quenching the aerosol including the particles to a collection temperature that does not condense any water onto the particles characterised in that the quench gas is an inert gas that does not react with the metals included in the multi-metallic particles, and
e. separating the multi-element, finely divided, alloy powder containing silver and at least two non-silver containing elements from the carrier gas, reaction by-products, and solvent volatilization products.

### Detailed Description of the Invention

### Definitions

As used herein with respect to the solvent for the silver-containing compound and the non-silver-containing metal compounds, the term "volatilizable" means that the solvent is completely converted to vapor or gas by the time the highest operating temperature is reached, whether by vaporization and/or by decomposition.

As used herein with respect to silver-containing compounds and non-silver-containing metal compounds, the term "thermally decomposable" means that the compound becomes fully decomposed to the metal and volatilized by-products by the time the highest operating temperature is reached. For example, AgNO₃, Co(NO₃)₂, Pd(NO₃)₂ are decomposed to form NOₓ and Ag and Pd metal, respectively.

Silver-containing Compound and Non-Silver-containing Metal Compounds:
Any soluble salt can be used in the method of the invention so long as it is inert with respect to the carrier gas used to form the aerosols. Examples include metal nitrates, phosphates, sulfates, acetates, and the like. Specific examples include the suitable salts: AgNO₃, Ag₃PO₄, Ag₂SO₄, Pd(NO₃)₂, Pd₃(PO₄)₂, Pt(NO₃)₂, Co(NO₃)₂, Co(C₂H₃O₂)₂, Pb(NO₃)₂ and the like. The silver-containing compound and non-silver-containing metal compounds may be used in concentrations as low as 0.2 mole/liter and upward to just below the solubility limit of the particular salt. In most embodiments concentrations are greater than about 0.2 mole/liter and less than about 90% of saturation.

In one embodiment water-soluble silver salts as the source of silver and water-soluble palladium salts as the source of palladium are used for the method of the invention. In another embodiment the method is carried out effectively with the use of other solvent-soluble compounds such as organometallic silver, palladium, or mixed silver palladium compounds dissolved in either aqueous or organic solvents. Very small, colloidal particles of the non-silver containing elements may also be used provided the particles form a stable suspension.

Operating Variables: The method of the invention can be carried out under a wide variety of operating conditions as long as the following fundamental criteria are met:
1. The concentration of the soluble silver-containing compound and the non-silver-containing metal compounds in the aerosol must be below the saturation concentration at the feed temperature and preferably at least 10% below the saturation concentration in order to prevent precipitation of solids before removal of the liquid solvent;
2. The concentration of droplets in the aerosol must be sufficiently low so that it is below the concentration where collisions and subsequent coalescence of the droplets results in a 10% reduction in droplet concentration;
3. The temperature of the reactor must be below the melting point of the formed alloy.

Though it is essential to operate under the saturation point of the soluble silver-containing compound and non-silver-containing metal compounds, their concentration is not otherwise critical in the operation of the process. Much lower concentrations of silver-containing and non-silver-containing compounds can be used. However, in general higher concentrations provide higher production rates of particles.

Any of the conventional apparatus for droplet generation may be used to prepare the aerosols for the invention such as nebulizers, Collison nebulizers, ultrasonic nebulizers, vibrating orifice aerosol generators, centrifugal atomizers, two-fluid atomizers, electrospray atomizers and the like. The particle size of the powder is a direct function of the droplet sizes generated. The size of the droplets in the aerosol is not critical in the practice of the method of the invention. However, as mentioned above, it is important that the number of droplets not be so great as to incur excessive coalescence which broadens the particle size distribution.

In addition, for a given aerosol generator, concentration of the solution of the silver-containing compound and the non-silver-containing metal compounds has an effect on particle size. In particular, particle size is an approximate function of the cube root of the concentration. Therefore, the higher the silver-containing and non-silver-containing compounds concentration, the larger the particle size of the precipitated metal alloy. If a greater change in particle size is needed, a different aerosol generator must be used.

Virtually any vaporous material which is inert with respect to the solvent for the silver -containing and non-silver-containing metal compounds and with respect to the compounds themselves may be used as the carrier gas for the practice of the invention. Examples of suitable vaporous materials are air, nitrogen, oxygen, steam, argon, helium, carbon dioxide and the like. In one emboidment air is the carrier gas to make the multi-element, finely divided, alloy powders containing silver and at least two non-silver containing elements where the non-silver containing elements form decomposable metal oxides below the operating temperatures of forming the metal alloy. At temperatures below 1200 °C, examples of these elements include Pt and Pd.

In another embodiment nitrogen is the carrier gas for elements that form stable metal oxides at temperatures below 1200 °C. Examples of these elements include Co, Mo, Fe, Mn, Cu, Ni, and the like. In some end uses the presence of metal oxides in the alloy powder is acceptable or desirable.

The process for making the mufti-element, finely divided, alloy powder containing silver and at least two non-silver containing elements where the non-silver containing elements include at least two of the following elements: Au, Bi. Cd, Co, Cr, Cu, Fe, Ge, Hg, In, Ir, Mn, Mo, Ni, Pd, Pb, Pt, Re, Rh, Ru, Sb, Sn, Ti, W, Zn is done when a co-solvent is added to the precursor solution. Suitable co-solvents are those that act as a reducing agent of the metal oxides, are vaporizable, are inert with respect to the carrier gas, are miscible with the primary solvent, and have a carbon number from 1 to 5 carbons. Examples of suitable co-solvents include alcohols, esters, ethers, ketones, and the like. These co-solvents are present in the solution in an amount from 1 % to 50%, preferably 5% to 20% by volume.

The temperature range over which the method of the invention can be carried out is quite wide and ranges from the decomposition temperature of the silver-containing compound or the non-silver-containing metal compounds whichever is greater, to the melting point of the formed multi-element alloy.

The type of apparatus used to heat the aerosol is not by itself critical and either direct or indirect heating may be used. For example, tube furnaces may be used or direct heating in combustion flames may be used. It is important to not go above the melting point of the formed multi-element, alloy powder containing silver and at least two non-silver containing elements.

Upon reaching the reaction temperature and the particles are alloyed, they are quenched, separated from the carrier gas, reaction by-products and solvent volatilization products and the powder collected by one or more devices such as filters, cyclones, electrostatic separators, bag filters, filter discs and the like. Upon completion of the reaction, the gas consists of the carrier gas, decomposition products of the metal compounds and solvent vapor. Thus, in the case of preparing silver palladium cobalt alloy particles from aqueous silver nitrate, palladium nitrate, and cobalt nitrate using nitrogen as the carrier gas, the effluent gas from the method of the invention will consist of nitrogen oxides, water and nitrogen gases.

The alloy powders of the invention are highly crystalline. Crystallite size exceeds 200 angstroms and typically exceeds 400 angstroms or more.

### EXAMPLES

The following examples are provided to aid in understanding of the present invention, and are not intended to in any way limit the scope of the present invention. The details of the powder characteristics are found in Table 1. Alloy compositions are presented in weight percent. The tap density was measured using a tap density machine manufactured by Englesmann. The surface area was measured using a Micromeritics Tristar using the BET method. The He pycnometry density was measured using a Micromeritics Accupyc 1330. The crystallite size and % metal oxide was measured using a Rigaku Miniflex x-ray diffractometer. The particle size data was measured using a Micromeritics S3500.

### Reference Example 1

This example demonstrates the manufacture of the multi-element, finely divided, alloy powder containing silver and palladium and platinum with the ratio of 85% silver, 10% palladium, and 5% platinum by weight. A precursor solution was prepared by the dissolution of silver nitrate crystals in water followed by the addition of palladium nitrate solution and then platinum nitrate solution. The total amount of silver, palladium, and platinum in the solution was 10 weight percent with the relative proportions so that if the silver and palladium and platinum fully alloyed, a 85/10/5 Ag/Pd/Pt alloy will be obtained in the particles. An aerosol was then generated using air as the carrier gas and an ultrasonic generator with 9 ultrasonic transducers operating at 1.6 MHz. This aerosol was then sent through an impactor and then sent into a 3 zone furnace with the zones set at 900 °C. After exiting the furnace, the aerosol temperature is quenched with air and the dense, spherical shape, finely divided alloy powder containing silver and palladium and platinum with the ratio of 85% silver, 10% palladium, and 5% platinum by weight were collected in a bag filter.

### Example 4

A sample of the multi-element, finely divided, alloy powder containing silver and palladium and platinum with the ratio of 82% silver, 17% palladium, and 1 % copper by weight was prepared using the same conditions as described in Example 1 except nitrogen gas was used for both the 1000 °C carrier gas and the quench gas.

### Example 5

A sample of the multi-element, finely divided, alloy powder containing silver and palladium and platinum with the ratio of 78% silver, 20% palladium, and 2% copper by weight was prepared using the same conditions as described in Example 1 except nitrogen gas was used for both the 1000 °C carrier gas and the quench gas.

### Reference Example 8 and 10

A sample of the multi-element, finely divided, alloy powder containing different ratios of silver and palladium and iron were prepared using the same conditions as described in Example 1 except nitrogen gas was used as the 1000 °C carrier gas. Under these conditions, some iron oxide was present as shown by x-ray diffraction.

### Example 9 and 11

A sample of the multi-element, finely divided, alloy powder containing different ratios of silver and palladium and iron were prepared using the same conditions as described in Example 1 except nitrogen gas was used as the 1000 °C carrier gas and as the quench gas. Under these conditions, some iron oxide was present as shown by x-ray diffraction, but the amount was less than seen in examples 8 and 10.

### Example 12

A sample of the multi-element, finely divided, alloy powder containing silver and palladium and molybdenum with the ratio of 75% silver, 15% palladium, and 10% molybdenum by weight was prepared using the same conditions as described in Example 1 except nitrogen gas was used for both the 1000 °C carrier gas and the quench gas.

### Examples 13 and 14

A sample of the multi-element, finely divided, alloy powder containing different ratios of silver and palladium and manganese were prepared using the same conditions as described in Example 1 except nitrogen gas was used as the 1000 °C carrier gas and as the quench gas. Under these conditions, some manganese oxide was present as shown by x-ray diffraction.

### Example 15

A sample of the multi-element, finely divided, alloy powder containing silver and zinc and platinum with the ratio of 89% silver, 10% zinc, and 1% platinum by weight was prepared using the same conditions as described in Example 1 except nitrogen gas was used for both the 1000 °C carrier gas and the quench gas. Under these conditions, some zinc oxide was present as shown by x-ray diffraction.

### Examples 16 and 17

A sample of the multi-element, finely divided, alloy powder containing different ratios of silver and manganese and platinum were prepared using the same conditions as described in Example 1 except nitrogen gas was used as the 1000 °C carrier gas and as the quench gas. Under these conditions, some manganese oxide was present as shown by x-ray diffraction.

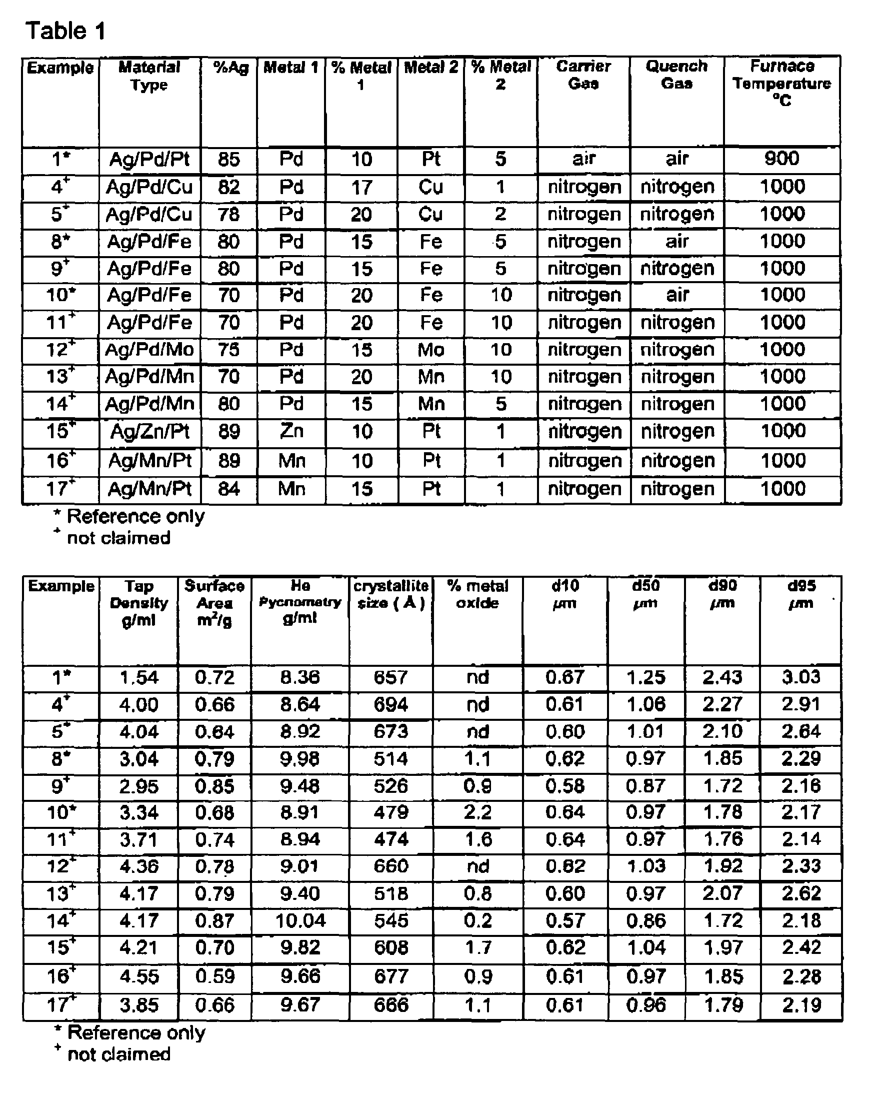

## Claims

1. A method for the manufacture of a multi-element, finely divided, alloy powder containing silver and at least two non-silver containing elements comprising the sequential steps:
a. forming a solution of a mixture of a thermally decomposable silver containing compound with at least two additional, non-silver containing thermally decomposable metal compounds in a thermally volatilizable solvent **characterised in that** a co-solvent is added to act as a reducing agent;
b. forming an aerosol consisting essentially of finely divided droplets of the solution from step A dispersed in a carrier gas, the droplet concentration which is below the concentration where collisions and subsequent coalescence of the droplets results in a 10% reduction in droplet concentration, where the carrier gas is an inert gas that does not react with the metals included in the multi-metallic particles;
c. heating the aerosol to an operating temperature above the decomposition temperature of the silver-containing compound and the non-silver containing compounds but below the melting point of the resulting multi-metallic alloy by which (1) the solvent is volatilized, (2) the silver-containing compound and the non-silver containing compounds are decomposed to form finely, divided particles, (3) the particles form an alloy and are densified; and
d. quenching the aerosol including the particles to a collection temperature that does not condense any water onto the particles **characterised in that** the quench gas is an inert gas that does not react with the metals included in the multi-metallic particles, and
e. separating the multi-element, finely divided, alloy powder containing silver and at least two non-silver containing elements from the carrier gas, reaction by-products, and solvent volatilization products.

2. The method as recited in claim 1 where the operating temperature is between 600 °C and 1500 °C.

3. The method, as recited in claim 1, where the silver content is greater than 50%.

4. The method as recited in claim 1 where the non-silver containing elements include at least two of the following elements: Au, Bi, Cd, Co, Cr, Cu, Fe, Ge, Hg, In, Ir, Mn, Mo, Ni, Pd, Pb, Pt, Re, Rh, Ru, Sb, Sn, Ti, W, Zn.

5. The method as recited in claim 1 where the carrier gas is selected from the group consisting of air, an inert gas that does not react with the metals included in the multi-metallic particles, nitrogen, a reducing gas, and nitrogen gas containing up to 4% hydrogen gas.

6. The method of claim 1 where the carrier gas and the quench gas are nitrogen gas containing up to 4% hydrogen gas.

7. The method of claim 1 where said co-solvent reducing agent is selected from the group consisting of an organic compound having 1 to 5 carbons and an alcohol.

8. The method, as recited in claim 1, where a tri-metallic alloy is formed and one of the non-silver containing elements is palladium and the other non-silver containing element is one of the following: Au, Bi, Cd, Co, Cr, Cu, Fe, Ge, Hg, In, Ir, Mn, Mo, Ni, Pb, Pt, Re, Rh, Ru, Sb, Sn, TI, W, Zn.

9. The method of claim 1 where the carrier gas is a reducing gas and a tri-metallic alloy is formed and one of the non-silver containing elements is palladium and the other is platinum.

10. The method of claim 1 for the manufacture of a highly crystalline alloy of finely divided, silver containing, multi-metallic particles where In step C (3) the particles are densified and made highly crystalline.

## Patentansprüche

1. Verfahren für die Herstellung eines feinverteilten Pulvers aus einer Multielementlegierung, enthaltend Silber und mindestens zwei nicht Silber enthaltende Elemente, umfassend die aufeinander folgenden Schritte:
a. Bilden einer Lösung eines Gemisches aus einer thermisch zersetzbaren Silber enthaltenden Verbindung mit mindestens zwei zusätzlichen, nicht Silber enthaltenden thermisch zersetzbaren Metallverbindungen in einem thermisch verflüchtigbaren Lösungsmittel, **dadurch gekennzeichnet, dass** ein Hilfslösungsmittel hinzugefügt wird, um als Reduktionsmittel zu wirken;
b. Bilden eines Aerosols, bestehend im Wesentlichen aus feinverteilten Tröpfchen der Lösung aus Schritt A, dispergiert in einem Trägergas, dessen Tröpfchenkonzentration unterhalb der Konzentration ist, wo Kollisionen und nachfolgende Koaleszenz der Tröpfchen zu einer 10 %igen Verringerung in der Tröpfchenkonzentration führen, wo das Trägergas ein inertes Gas ist, das nicht mit den Metallen, eingeschlossen in den Multimetallpartikeln, reagiert;
c. Erhitzen des Aerosols auf eine Betriebstemperatur oberhalb der Zersetzungstemperatur der Silber enthaltenden Verbindung und der nicht Silber enthaltenden Verbindungen, aber unterhalb des Schmelzpunkts der resultierenden Multimetalllegierung, durch welche (1) das Lösungsmittel verflüchtigt wird, (2) die Silber enthaltende Verbindung und die nicht Silber enthaltenden Verbindungen zersetzt werden, um feinverteilte Partikel zu bilden, (3) die Partikel eine Legierung bilden und verdichtet werden; und
d. Abschrecken des Aerosols, einschließend die Partikel, zu einer Sammlungstemperatur, die nicht irgendwelches Wasser auf den Partikeln kondensiert, **dadurch gekennzeichnet, daß** das Abschreckungsgas ein inertes Gas ist, das nicht mit den Metallen, eingeschlossen in den Multimetallpartikeln, reagiert; und
e. Abtrennen des feinverteilten Pulvers aus der Multielementlegierung, enthaltend Silber und mindestens zwei nicht Silber enthaltende Elemente, von dem Trägergas, den Reaktionsnebenprodukten und den Produkten der Lösungsmittelverflüchtigung.

2. Verfahren, wie in Anspruch 1 angeführt, wo die Betriebstemperatur zwischen 600°C und 1500°C ist.

3. Verfahren, wie in Anspruch 1 angeführt, wo der Silbergehalt größer als 50% ist.

4. Verfahren, wie in Anspruch 1 angeführt, wo die nicht Silber enthaltenden Elemente mindestens zwei der folgenden Elemente einschließen: Au, Bi, Cd, Co, Cr, Cu, Fe, Ge, Hg, In, Ir, Mn, Mo, Ni, Pd, Pb, Pt, Re, Rh, Ru, Sb, Sn, Ti, W, Zn.

5. Verfahren, wie in Anspruch 1 angeführt, wo das Trägergas aus der Gruppe, bestehend aus Luft, einem inerten Gas, das nicht mit den Metallen, eingeschlossen in den Multimetallpartikeln, reagiert, Stickstoff, einem reduzierenden Gas und Stickstoffgas, enthaltend bis zu 4% Wasserstoffgas, ausgewählt ist.

6. Verfahren nach Anspruch 1, wo das Trägergas und das Abschreckungsgas Stickstoffgas, enthaltend bis zu 4% Wasserstoffgas, sind.

7. Verfahren nach Anspruch 1, wo das Reduktionsmittel in Form eines Hilfslösungsmittels aus der Gruppe, bestehend aus einer organischen Verbindung mit 1 bis 5 Kohlenstoffatomen und einem Alkohol, ausgewählt ist.

8. Verfahren, wie in Anspruch 1 angeführt, wo eine Trimetalllegierung gebildet wird und eines von den nicht Silber enthaltenden Elementen Palladium ist und das andere nicht Silber enthaltende Element eines der folgenden ist: Au, Bi, Cd, Co, Cr, Cu, Fe, Ge, Hg, In, Ir, Mn, Mo, Ni, Pb, Pt, Re, Rh, Ru, Sb, Sn, Ti, W, Zn.

9. Verfahren nach Anspruch 1, wo das Trägergas ein reduzierendes Gas ist und eine Trimetalllegierung gebildet wird und eines von den nicht Silber enthaltenden Elementen Palladium ist und das andere Platin ist.

10. Verfahren nach Anspruch 1 für die Herstellung einer in hohem Maße kristallinen Legierung aus feinverteilten, Silber enthaltenden, Multimetallpartikeln, wo in Schritt C (3) die Partikel verdichtet und in hohem Maße kristallin gemacht werden.

## Revendications

1. Procédé pour la fabrication d'une poudre d'alliage, finement divisée, à multiples éléments contenant de l'argent et au moins deux éléments ne contenant pas d'argent comprenant les étapes séquentielles:
a. de formation d'une solution d'un mélange d'un composé contenant de l'argent thermiquement décomposable avec au moins deux composés métalliques thermiquement décomposables supplémentaires, ne contenant pas d'argent dans un solvant thermiquement volatilisable **caractérisée en ce qu'**un co-solvant est ajouté pour agir comme un agent réducteur;
b. de formation d'un aérosol constitué essentiellement de gouttelettes finement divisées de la solution provenant de l'étape A dispersées dans un gaz porteur, la concentration des gouttelettes étant en dessous de la concentration à laquelle des collisions et une coalescence subséquente des gouttelettes conduisent à une réduction de 10% de la concentration des gouttelettes, où le gaz porteur est un gaz inerte qui ne réagit pas avec les métaux inclus dans les particules des multiples métaux;
c. de chauffage de l'aérosol à une température de fonctionnement au-dessus de la température de décomposition du composé contenant de l'argent et des composés ne contenant pas d'argent mais en dessous du point de fusion de l'alliage à multiples métaux résultant par lequel (1) le solvant est volatilisé, (2) le composé contenant de l'argent et les composés ne contenant pas d'argent sont décomposés pour former des particules finement divisées, (3) les particules forment un alliage et sont densifiées; et
d. de trempe de l'aérosol incluant les particules à une température de récupération qui ne condense pas d'eau sur les particules **caractérisée en ce que** le gaz de trempe est un gaz inerte qui ne réagit pas avec les métaux inclus dans les particules des multiples métaux, et
e. de séparation de la poudre d'alliage, finement divisée, à multiples éléments contenant de l'argent et au moins deux éléments ne contenant pas d'argent à partir du gaz porteur, des sous-produits de réaction et des produits de volatilisation du solvant.

2. Procédé selon la revendication 1, dans lequel la température de fonctionnement est entre 600°C et 1500°C.

3. Procédé selon la revendication 1, dans lequel la teneur en argent est de plus de 50%.

4. Procédé selon la revendication 1, dans lequel les éléments ne contenant pas d'argent incluent au moins deux des éléments suivants: Au, Bi, Cd, Co, Cr, Cu, Fe, Ge, Hg, In, Ir, Mn, Mo, Ni, Pd, Pb, Pt, Re, Rh, Ru, Sb, Sn, Ti, W, Zn.

5. Procédé selon la revendication 1, dans lequel le gaz porteur est choisi dans le groupe constitué d'air, d'un gaz inerte qui ne réagit pas avec les métaux inclus dans les particules à multiples métaux, d'azote, d'un gaz réducteur et d'azote gazeux contenant jusqu'à 4% d'hydrogène gazeux.

6. Procédé selon la revendication 1, dans lequel le gaz porteur et le gaz de trempe sont de l'azote gazeux contenant jusqu'à 4% d'hydrogène gazeux.

7. Procédé selon la revendication 1, dans lequel ledit agent réducteur co-solvant est choisi dans le groupe constitué d'un composé organique possédant de 1 à 5 carbones et d'un alcool.

8. Procédé selon la revendication 1, dans lequel un alliage tri-métallique est formé et un des éléments ne contenant pas d'argent est le palladium et l'autre élément ne contenant pas d'argent est un de ce qui suit: Au, Bi, Cd, Co, Cr, Cu, Fe, Ge, Hg, In, Ir, Mn, Mo, Ni, Pb, Pt, Re, Rh, Ru, Sb, Sn, Ti, W, Zn.

9. Procédé selon la revendication 1, dans lequel le gaz porteur est un gaz réducteur et un alliage tri-métallique est formé et un des éléments ne contenant pas d'argent est le palladium et l'autre est le platine.

10. Procédé selon la revendication 1 pour la fabrication d'un alliage hautement cristallin de particules à multiples métaux, contenant de l'argent, finement divisées, dans lequel, dans l'étape C (3), les particules sont densifiées et rendues hautement cristallines,
